# DEMANDE DE BREVET EUROPEEN

(11) **EP 2 278 617 A2**
(43) Date de publication de la demande: **26.01.2011**
(21) Numéro de dépôt: 10169734.0
(22) Date de dépôt: 15.07.2010
(51) Int. Cl.: H01L 23/48

(54) **Via électrique à surface latérale rugueuse**

(30) Priorité: 21.07.2009 FR 0955053
(71) Demandeur: STMicroelectronics (Crolles 2) SAS, 38920 Crolles (FR)
(72) Inventeur: Chaabouni, Hamed, 38000, Grenoble (FR); Cadix, Lionel, 38000, Grenoble (FR)
(74) Mandataire: de Beaumont, Michel

(57) **Abrégé**

L'invention concerne un via (23) reliant la face avant à la face arrière d'un substrat semiconducteur (W1), ce via ayant une surface latérale rugueuse.

## Description

### Domaine de l'invention

La présente invention concerne une connexion électrique isolée entre la face avant et la face arrière d'un substrat, couramment désignée dans la technique par le terme via.

### Exposé de l'art antérieur

Parmi les nombreux domaines d'utilisation des vias, on peut citer les dispositifs à empilement de puces. Dans ces dispositifs, on prévoit de superposer des puces ou des tranches semiconductrices, accolées les unes aux autres. Ceci permet d'augmenter les fonctions réalisées par un dispositif sans augmenter la surface occupée.

Dans ces dispositifs, les connexions entre les composants des différents étages peuvent être réalisées soit par des techniques traditionnelles de câblage filaire, soit par des vias traversant le substrat des puces.

Un avantage des vias réside dans la possibilité de les fabriquer collectivement, contrairement aux fils pour lesquels un montage unitaire doit être réalisé. Les autres principaux avantages des vias par rapport aux fils résident dans le gain de surface qu'ils apportent, l'amélioration des performances électriques, et la possibilité de répartition en surface des entrées/sorties. Un autre avantage de la connexion par vias est que ces vias seront couramment réalisés dans des tranches de silicium. Ces tranches de silicium seront ensuite assemblées de diverses manières dont celle décrite ci-après, puis pourront être découpées en puces individuelles. De tels procédés collectifs conduisent à des réductions de coût. Dans la présente description, on mentionnera des assemblages de puces, mais il sera clair que ces puces pourront être des plaques, des tranches semiconductrices ou des éléments de tranches semiconductrices.

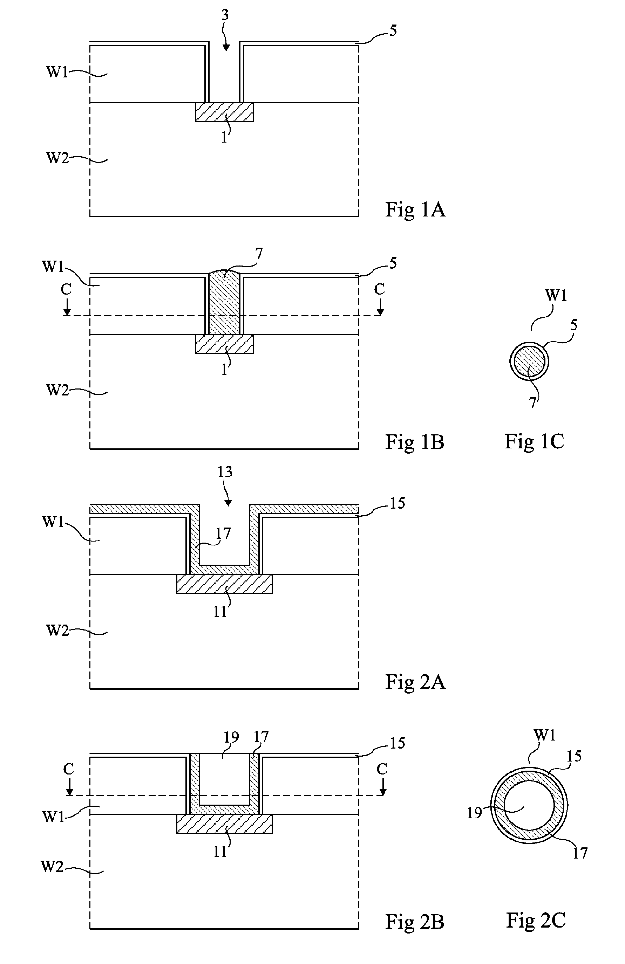

Les figures 1A et 1B sont des vues de côté en coupe illustrant des étapes d'un procédé de réalisation d'un via plein de diamètre inférieur à 10 µm, par exemple de l'ordre de 0,5 à 10 µm. La figure 1C est une vue de dessus en coupe selon le plan C-C de la figure 1B, et représente une section du via réalisé.

Une puce ou tranche semiconductrice amincie W1 est superposée à une puce ou tranche semiconductrice W2. Les puces W1 et W2 sont par exemple collées entre elles par adhérence moléculaire. L'amincissement de la puce W1 peut être réalisé avant ou après le collage. Les puces W1 et W2 sont chacune formées dans un substrat semiconducteur, selon des procédés de réalisation classiques. Elles comportent notamment chacune des zones actives, dans lesquelles sont formés des composants, et un empilement de pistes conductrices d'interconnexion, par exemple des pistes de cuivre, reliant les composants entre eux et aux entrées/sorties. A la surface de la puce W2, du côté de la face commune aux puces W1 et W2, il est prévu un plot de contact conducteur 1, correspondant par exemple à une portion de cuivre d'un niveau d'interconnexion supérieur. Le plot de contact 1 est relié à une borne de la puce par des pistes conductrices non représentées de façon à pouvoir être connecté à un potentiel de référence lors d'une étape ultérieure de dépôt électrolytique.

Un trou 3, traversant de part en part le substrat de la puce W1, est formé en regard du plot de contact 1. Le trou 3 peut être percé par gravure sèche ou gravure chimique. Une isolation des parois du trou 3 est réalisée, par exemple par dépôt d'une couche 5 d'oxyde de silicium. La portion de la couche isolante 5 recouvrant, au fond du trou 3, le plot de contact 1, est retirée pour laisser le plot 1 accessible.

L'assemblage ainsi réalisé est plongé dans une solution électrolytique conductrice adaptée, par exemple de sulfate de cuivre. Le plot de contact 1 est mis à un potentiel négatif et forme une cathode. Une anode de cuivre, reliée à un potentiel positif, est plongée dans la solution électrolytique. Il circule alors un courant entre l'anode et la cathode. Du cuivre se dépose progressivement par électrolyse sur la cathode, venant remplir le trou 3. L'électrolyse est interrompue lorsque le trou 3 est plein, formant ainsi un via conducteur cylindrique 7. On peut en outre prévoir une étape de planarisation, pour égaliser la surface du via 7 après l'électrolyse.

Pour des diamètres supérieurs à quelques µm, la formation de vias par électrolyse serait trop longue et trop coûteuse à mettre en oeuvre.

Les figures 2A et 2B sont des vues de côté en coupe illustrant des étapes de réalisation d'un via creux de diamètre supérieur à 10 µm, par exemple de l'ordre de 10 à 200 µm. La figure 2C est une vue de dessus en coupe selon le plan C-C de la figure 2B, et représente une section du via réalisé.

Des puces ou tranches semiconductrices W1 et W2 sont superposées de la façon décrite ci-dessus. A la surface de la puce W2, du côté de la face commune aux puces W1 et W2, il est prévu un plot de contact conducteur 11, correspondant par exemple à une portion de cuivre d'un niveau d'interconnexion supérieur.

Un trou 13 traversant de part en part la puce W1, est percé en regard du plot 11. Une gaine d'isolation des parois du trou 13 est formée, par exemple par dépôt d'une couche 15 d'oxyde de silicium. La portion de la couche isolante 15 recouvrant le plot de contact 11 est retirée pour laisser le plot 11 accessible.

Une couche conductrice 17, par exemple une couche de cuivre, est formée par dépôt conforme sur les parois isolées et sur le fond du trou 13. La couche 17 forme un contact avec le plot 11 de la puce W2.

Les portions de la couche 17 à la surface de la puce W1 sont retirées pour ne conserver que la partie appliquée sur les parois isolées et sur le fond du trou 13. La partie restante de la couche 17 forme ainsi un via tubulaire 17, ayant en vue de dessus la forme d'un anneau.

Le via 17 est généralement comblé par une résine de remplissage 19.

En fonctionnement, lorsque les vias sont parcourus par des courants, ils produisent par effet Joule de la chaleur. Il en résulte une élévation de leur température, pouvant conduire à des dégradations ou à une réduction de la durée de vie des puces.

### Résumé

Un objet d'un mode de réalisation de la présente invention est de pallier tout ou partie des inconvénients des vias classiques.

Un objet d'un mode de réalisation de la présente invention est de proposer une structure de via permettant de limiter l'élévation de la température du via lorsqu'il est parcouru par un courant.

Ainsi, un mode de réalisation de la présente invention prévoit un via reliant la face avant à la face arrière d'un substrat semiconducteur, ce via ayant une surface latérale rugueuse.

Selon un mode de réalisation de la présente invention, la surface latérale rugueuse repose sur une surface d'une couche de silicium rugueux.

Selon un mode de réalisation de la présente invention, la couche de silicium rugueux est une couche de silicium à grains hémisphériques.

Selon un mode de réalisation de la présente invention, le via susmentionné est isolé du substrat par une couche mince d'un matériau électriquement isolant.

Selon un mode de réalisation de la présente invention, le matériau électriquement isolant est thermiquement conducteur.

Un mode de réalisation de la présente invention prévoit un procédé de fabrication d'un via reliant la face avant à la face arrière d'un substrat, comportant les étapes successives suivantes : a) percer un trou traversant le substrat de part en part ; b) recouvrir les parois latérales du trou d'un film de silicium polycristallin ou amorphe ; c) rendre rugueuse la surface extérieure du film ; et d) recouvrir la surface extérieure du film et le fond du trou d'un matériau électriquement conducteur.

Selon un mode de réalisation de la présente invention, l'étape c) comporte la formation de silicium à grains hémisphériques par un double recuit thermique, sous atmosphère contrôlée contenant du silane, puis sous vide.

Selon un mode de réalisation de la présente invention, chacun des recuits successifs est effectué à une température comprise entre 300°C et 600°C.

Selon un mode de réalisation de la présente invention, il est prévu, entre les étapes c) et d), une étape de formation d'une couche mince d'un matériau électriquement isolant.

Selon un mode de réalisation de la présente invention, le matériau électriquement conducteur est du cuivre.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A et 1B, précédemment décrites, sont des vues de côté en coupe illustrant des étapes de réalisation d'un via plein de diamètre inférieur à 10 µm ;
la figure 1C, précédemment décrite, est une vue de dessus en coupe de la figure 1B représentant une section d'un via plein ;
les figures 2A et 2B, précédemment décrites, sont des vues de côté en coupe illustrant des étapes de réalisation d'un via tubulaire de diamètre supérieur à 10 µm ;
la figure 2C, précédemment décrite est une vue de dessus en coupe de la figure 2B représentant une section d'un via tubulaire ;
la figure 3 est une vue de côté en coupe représentant de façon schématique un mode de réalisation d'un via plein de diamètre inférieur à 10 µm ;
les figures 4A à 4E sont des vues de côté en coupe illustrant des étapes successives d'un exemple de procédé de réalisation du via de la figure 3 ; et
la figure 5 est une vue de côté en coupe représentant de façon très schématique un mode de réalisation d'un via creux de diamètre supérieur à 10 µm.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Les inventeurs ont étudié les phénomènes de dissipation de la chaleur produite dans un via.

Une première partie de la chaleur se propage à partir du haut et du bas du via vers les pistes d'interconnexion de la puce. Toutefois, la surface de dissipation fournie par les pistes d'interconnexion est faible. En outre, des couches isolantes, généralement d'oxyde de silicium, sont intercalées entre les niveaux d'interconnexion successifs. Il en résulte que la dissipation de chaleur par l'intermédiaire des pistes d'interconnexion est faible.

Une deuxième partie de la chaleur est dissipée, à partir de la surface latérale externe du via, à travers la gaine isolante, dans le corps du substrat. Toutefois, la faible conductivité thermique de la gaine isolante limite la dissipation de chaleur dans le corps du substrat.

On cherche ici à améliorer les échanges thermiques entre un via et le corps du substrat qu'il traverse, de façon à réduire l'élévation de la température du via.

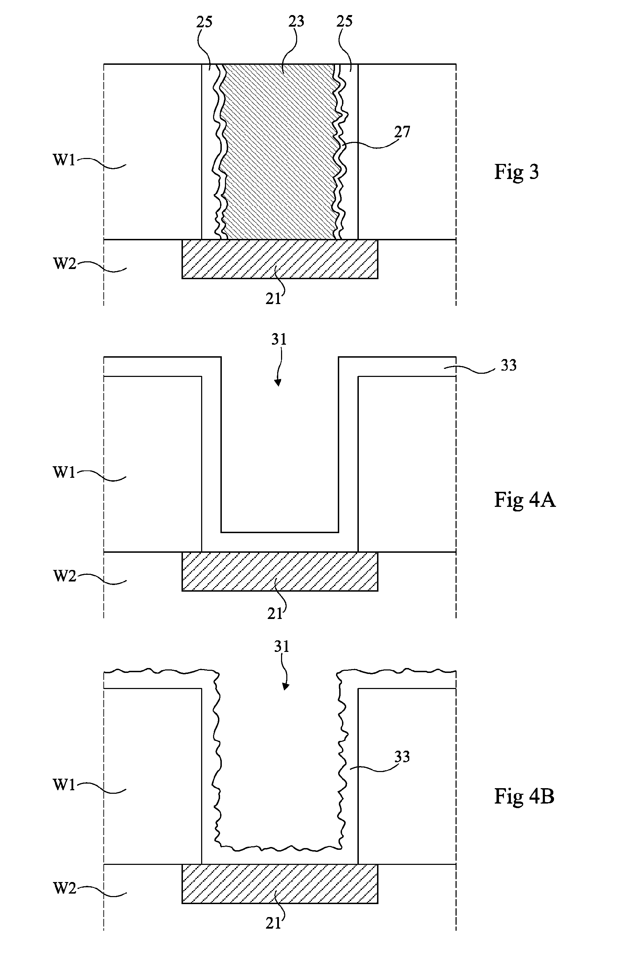

La figure 3 est une vue de côté en coupe illustrant de façon très schématique un exemple d'un mode de réalisation d'un via plein de diamètre inférieur à 10 µm.

Une puce ou tranche semiconductrice amincie W1 est superposée à une puce ou tranche semiconductrice W2 de la façon décrite en relation avec les figures 1A et 1B. Au niveau de la face commune aux puces W1 et W2, il est prévu un plot de contact conducteur 21, correspondant par exemple à une portion de cuivre d'un niveau d'interconnexion supérieur de la puce W2. Le plot de contact 21 est relié à une borne de la puce par des pistes conductrices non représentées de façon à pouvoir être connecté à un potentiel de référence lors d'une étape d'électrolyse décrite ci-après.

Un via plein 23, constitué d'un matériau électriquement conducteur, traverse de part en part la puce W1 et forme un contact avec le plot 21 de la puce W2.

Autour du via 23 s'étend une couronne de silicium 25, à surface latérale interne rugueuse. Comme cela sera expliqué plus en détail ci-après, on connaît des méthodes pour déposer une couche de silicium sur un substrat, puis rendre la surface de cette couche rugueuse. De telles méthodes conduisent par exemple à la formation d'une structure à grains hémisphériques, couramment désigné dans la technique par "HSG-Si", de l'anglais "Hemispherical Grain Silicon".

La surface latérale du via 23 repose sur la surface latérale interne rugueuse de la couronne 25. On entend par là que la surface du via se conforme à la surface rugueuse de la couronne 25, présentant des aspérités ou rugosités, en regard des plis ou creux de la surface interne de la couronne 25, et des plis ou creux en regard des aspérités ou rugosités de cette surface. La surface latérale du via plein 23 est donc rugueuse.

Dans l'exemple représenté, une couche isolante 27, constituée par exemple d'oxyde de silicium, isole du substrat le via 23.

Un avantage du mode de réalisation proposé est que la surface de contact entre le via à surface latérale rugueuse et la couche isolante d'oxyde de silicium est augmentée par rapport au cas des vias classiques à surface latérale lisse. Il en résulte une augmentation des échanges thermiques entre le via et le substrat de la puce. Ceci limite l'élévation de température du via et les risques de dégradation associés.

Les figures 4A à 4E sont des vues de côté en coupe illustrant des étapes successives d'un exemple de procédé de réalisation du via de la figure 3.

La figure 4A représente une puce ou tranche semiconductrice W1 accolée à une puce ou tranche semiconductrice W2 de la façon décrite en relation avec les figures 1A et 1B. La puce W2 comporte, du côté de sa face commune avec la puce W1, un plot conducteur 21 en contact avec la puce W1.

Un trou 31 traversant de part en part la puce W1 en regard du plot de contact 21 est percé, par exemple par gravure sèche ou chimique.

Une couche de silicium 33 est alors déposée, recouvrant les parois et le fond du trou 31 ainsi que la surface du substrat de la puce W1. Les conditions du dépôt de la couche 33 ne doivent pas conduire à des dégradations des puces W1 et W2. A titre d'exemple, on pourra réaliser un dépôt à basse température et basse pression d'une couche de silicium amorphe ou de silicium polycristallin.

La figure 4B illustre une étape consistant à rendre rugueuse la couche de silicium 33. On pourra par exemple utiliser une méthode conduisant à la formation de grains hémisphériques à la surface de la couche 33 (HSG-Si). Une telle méthode comprend notamment un double recuit thermique de la couche 33, sous atmosphère contrôlée contenant par exemple du silane (SiH₄), puis sous vide. On prendra soin de choisir convenablement la température des recuits de façon à ne pas endommager les puces W1 et W2. On pourra par exemple réaliser des recuits d'une durée de quelques dizaines de minutes à une température de l'ordre de 450°C. Ceci conduit à des inégalités de surface de l'ordre de 5 à 50 nm.

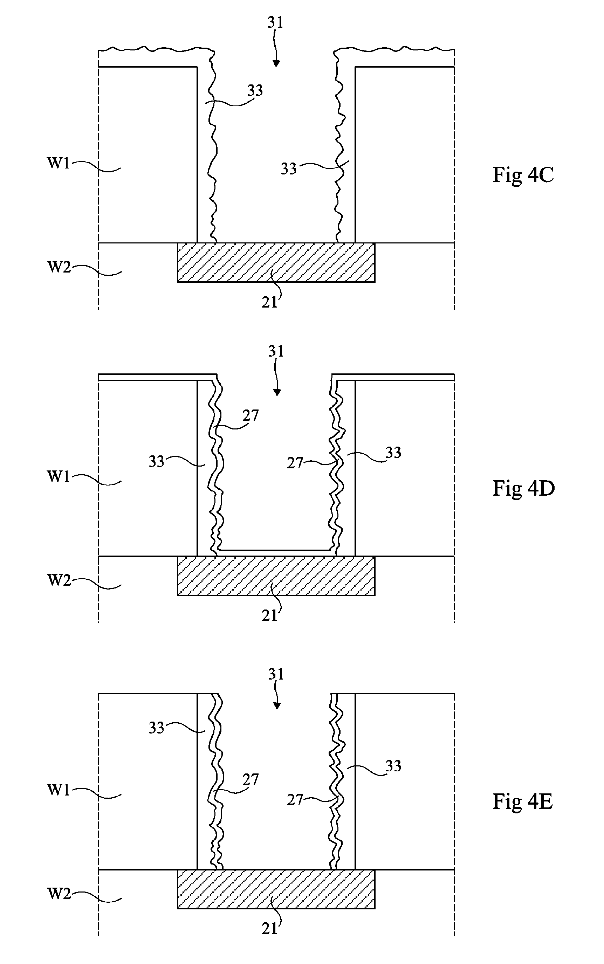

La figure 4C illustre une étape de retrait des portions de la couche rugueuse 33 recouvrant la surface de la puce W1 et le fond du trou 31. A l'issue de cette étape, ne sont conservées que les portions de la couche 33 recouvrant les parois latérales du trou 31.

La figure 4D illustre une étape de dépôt d'une couche isolante 27, par exemple d'oxyde de silicium. A titre d'exemple, la couche 27 pourra être formée par dépôt conforme ou par oxydation thermique.

La figure 4E illustre une étape de retrait des portions de la couche isolante 27 recouvrant la surface de la puce W1 et le fond du trou 31. A l'issue de cette étape, ne sont conservées que les portions de la couche 27 recouvrant la surface latérale interne de la couronne rugueuse 33.

La partie conductrice principale du via 23 représenté en figure 3 est alors formée lors d'une étape non représentée, par exemple en remplissant le trou 31 d'un matériau conducteur par dépôt électrolytique de la façon décrite en relation avec les figures 1A à 1C.

On a décrit ici un exemple de réalisation d'un via plein de diamètre inférieur à 10 µm. Toutefois, on pourra également réaliser un via creux de diamètre supérieur à quelques µm, par exemple de l'ordre de 10 à 200 µm, similaire aux vias du type décrit en relation avec les figures 2A à 2C, et à surface latérale rugueuse.

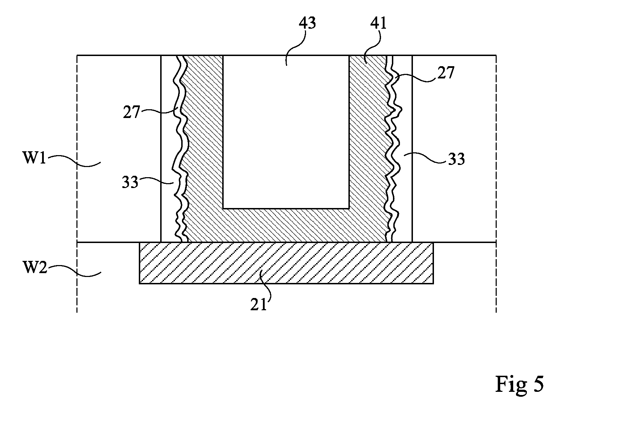

La figure 5 est une vue de côté en coupe représentant de façon schématique un tel via creux 41. Le via 41 peut être réalisé selon un procédé similaire à celui décrit en relation avec les figures 4A à 4E, à la différence que la partie conductrice du via n'est pas formée par dépôt électrolytique, mais par exemple par dépôt conforme, selon le mode de réalisation d'un via creux décrit en relation avec les figures 2A et 2B. Le trou 31 peut alors être comblé par une résine de remplissage 43.

Des modes de réalisation particuliers de la présente invention ont été décrits. Diverses variantes et modifications apparaîtront à l'homme de l'art. En particulier, l'invention ne se limite pas au seul procédé de formation d'une couche de silicium rugueux décrit en relation avec les figures 4A à 4E. Tout autre procédé adapté à rendre rugueuse la surface d'un substrat pourra être utilisé.

De plus, dans le cas d'un via tubulaire, pour augmenter encore la surface d'échange entre le via et le substrat, on pourra prévoir un via ayant, en coupe dans un plan parallèle aux faces avant et arrière du substrat, la forme d'un anneau festonné.

En outre, la présente description mentionne des vias et des pistes d'interconnexion en cuivre. Toutefois, l'invention ne se limite pas à ce seul cas particulier. L'homme de l'art saura également mettre en oeuvre le fonctionnement recherché en utilisant d'autres métaux ou matériaux conducteurs, par exemple du silicium polycristallin fortement dopé, pour former la partie conductrice des vias.

De plus, l'invention ne se limite pas aux procédés de formation de la partie conductrice du via par dépôt électrolytique ou par dépôt conforme, tel que mentionné ci-dessus. A titre d'exemple, la partie conductrice du via pourra être déposée par voie chimique en phase vapeur de silicium polycristallin. Ce silicium sera fortement dopé pour être rendu conducteur.

De même, l'homme de l'art saura mettre en oeuvre le fonctionnement recherché quels que soient les matériaux isolants utilisés pour former les diverses couches isolantes mentionnées dans la description. En particulier, la gaine d'isolation du via est inutile dans le cas d'un substrat isolant. Dans le cas d'un substrat conducteur, pour améliorer encore les échanges thermiques entre un via et le substrat, la gaine pourra être constituée d'un matériau électriquement isolant mais thermiquement conducteur.

## Revendications

1. Via (23) reliant la face avant à la face arrière d'un substrat semiconducteur (W1), ce via ayant une surface latérale rugueuse reposant sur une surface d'une couche de silicium rugueux (33).

2. Via selon la revendication 1, dans lequel ladite couche de silicium rugueux (33) est une couche de silicium à grains hémisphériques.

3. Via selon la revendication 1 ou 2, isolé du substrat par une couche mince d'un matériau électriquement isolant (27).

4. Via selon la revendication 3, dans lequel ledit matériau électriquement isolant est thermiquement conducteur.

5. Procédé de fabrication d'un via (23) reliant la face avant à la face arrière d'un substrat, comportant les étapes successives suivante :
a) percer un trou (31) traversant le substrat (W1) de part en part ;
b) recouvrir les parois latérales du trou d'un film de silicium polycristallin ou amorphe (33) ;
c) rendre rugueuse la surface extérieure du film ; et
d) recouvrir la surface extérieure du film et le fond du trou d'un matériau électriquement conducteur.

6. Procédé selon la revendication 5, dans lequel l'étape c) comporte la formation de silicium à grains hémisphériques par un double recuit thermique, sous atmosphère contrôlée contenant du silane, puis sous vide.

7. Procédé selon la revendication 6, dans lequel chacun des recuits successifs est effectué à une température comprise entre 300°C et 600°C.

8. Procédé selon l'une quelconque des revendications 5 à 7, comportant, entre les étapes c) et d), une étape de formation d'une couche mince d'un matériau électriquement isolant (27).

9. Procédé selon l'une quelconque des revendications 5 à 8, dans lequel ledit matériau électriquement conducteur est du cuivre.
